## Europäisches Patentamt

## European Patent Office

## Office européen des brevets

(19)

(11) Veröffentlichungsnummer: **0 171 579**
**B1**

(12)

# EUROPÄISCHE PATENTSCHRIFT

(45) Veröffentlichungstag der Patentschrift:
**09.03.88**

(51) Int. Cl.⁴: **G 01 D 5/245**

(21) Anmeldenummer: **85108271.9**

(22) Anmeldetag: **04.07.85**

(54) Anordnung zur seriellen Übertragung der Messwerte wenigstens eines Messwertwandlers.

(30) Priorität: **13.07.84 DE 3425818**

(43) Veröffentlichungstag der Anmeldung:
**19.02.86 Patentblatt 86/8**

(45) Bekanntmachung des Hinweises auf die Patenterteilung:
**09.03.88 Patentblatt 88/10**

(84) Benannte Vertragsstaaten:
**AT CH DE FR GB IT LI SE**

(56) Entgegenhaltungen:
**DE - B - 2 719 302**
**DE - B - 2 801 209**

(73) Patentinhaber: **Max Stegmann Gmbh Uhren- und Elektroapparatefabrik, Dürrhelmer Strasse 36, D-7710 Donauschingen (DE)**

(72) Erfinder: **Siraky, Josef, Dipl.-Ing., Brigachtalstrasse 31, D-7710 Donaueschingen 13 (DE)**

(74) Vertreter: **Patentanwälte Dipl.-Ing. Klaus Westphal Dr. rer. nat. Bernd Mussgnug Dr. rer.nat. Otto Buchner, Waldstrasse 33, D-7730 VS-Villingen (DE)**

**Beschreibung**

Die Erfindung betrifft eine Anordnung zur seriellen Übertragung der Messwerte wenigstens eines Messwertwandlers, insbesondere eines Winkelcodierers oder Wegmesscodierers, gemäss dem Oberbegriff des Patentanspruchs 1.

Messwertwandler, wie z.B. Winkelcodierer oder Wegmesscodierer, die einen absoluten Messwert aufnehmen und in eine digital-codierte Form umwandeln, werden insbesondere im industriellen Einsatz häufig mechanisch sehr stark beansprucht. Sie sind grossen Erschütterungen und starken elektromagnetischen Störfeldern ausgesetzt. Ausserdem ist mit Schmutz, Staub und Flüssigkeiten in unmittelbarer Nähe des Messwertwandlers zu rechnen. Es ist daher notwendig, den Messwertwandler mechanisch robust zu gestalten und die Anzahl der eingebauten elektronischen und elektromechanischen Bauelemente minimal zu halten. Wesentlich ist insbesondere auch die Störsicherheit der Übertragung der Messwertdaten von dem Messwertwandler zu der zugehörigen Verarbeitungseinheit, beispielsweise einer Steuerungseinheit.

Aus der DE-AS 2 719 302 ist eine Anordnung der eingangs genannten Gattung bekannt, bei welcher mehrere Paare von Messwertwandlern und zugehörigen Messwertempfängern über eine gemeinsame Datenleitung zur Messwertübertragung miteinander verbunden sind. Jedem Messwertwandler ist ein Parallel-Serien-Umsetzer zugeordnet, an welchem der jeweilige Messwert in binärer Codierung parallel ansteht. Die Messwerte der verschiedenen Messwertwandler werden über die Datenleitung im Zeitmultiplex seriell übertragen. Die Synchronisation zwischen den Messwertwandlern und den Empfängern wird durch Taktimpulsfolgen bewirkt, die von einer Taktimpulsquelle über eine für alle Messwertwandler und Empfänger gemeinsame Taktleitung an die Messwertwandler und Empfänger geführt werden.

Die Taktimpulsfolgen weisen dabei Adressensignale auf, durch welche die verschiedenen Messwertwandler und Empfänger paarweise aufeinanderfolgend adressiert werden. Die Messwertwandler und Empfänger sind hierzu jeweils mit Zählern versehen, die die Adressensignale der Taktimpulsfolgen zählen und jeweils nach einer für jedes Messwertwandler-Empfänger-Paar vorgegebenen Impulszahl über einen Decoder den zugehörigen Parallel-Serien-Umsetzer für die Datenübertragung aktivieren. Eine retriggerbare Zeitstufe dient dazu, am Ende jeder Taktimpulsfolge die Zähler sämtlicher Messwertwandler-Empfänger-Paare für den nächsten Adressierzyklus rückzusetzen.

Die zyklische Abfrage der Messwertwandler macht die bekannte Anordnung aufwendig. Jedem Messwertwandler muss ein Zähler zugeordnet sein, um das Adressensignal festzustellen und den entsprechenden Parallel-Serien-Umsetzer für die Datenübertragung zu aktivieren. Dies bedeutet einen hohen elektronischen Aufwand. Insbesondere ist auch eine grosse Anzahl von elektronischen Bauteilen im Bereich des Messwertwandlers erforderlich, die starken äusseren Beanspruchungen ausgesetzt sind. Die Adressierung der einzelnen Messwertwandler über die Taktimpulsfolge vergrössert die Zahl der Impulse der Taktimpulsfolgen, so dass die Messwerte nur mit relativ geringer Geschwindigkeit, d.h. mit geringer Baudrate übertragen werden können.

Aus der DE-AS 2 801 209 ist eine Anordnung bekannt, bei welcher mehrere Messwertwandler in Reihe in eine Ringleitung geschaltet sind. Die an den Parallel-Serien-Schieberegistern der einzelnen Messwertwandler parallel anstehenden Messwerte werden über diese Ringleitung seriell übertragen. Dazu dienen Taktimpulsfolgen, die von der die Messwerte aufnehmenden Verarbeitungseinheit über die Ringleitung zugeführt werden. Die Reihenanordnung der Messwertwandler in der Ringleitung macht eine Adressierung der einzelnen Messwertwandler bei der Übertragung notwendig. Auch hier erhöht die Adressierung somit den elektronischen Aufwand insgesamt und insbesondere am Ort des Messwertwandlers, der starken äusseren Beanspruchungen ausgesetzt ist. Ausserdem verringert die Adressierung durch die Taktimpulsfolgen die Datenübertragungsgeschwindigkeit.

Der Erfindung liegt die Aufgabe zugrunde, eine Anordnung zur Übertragung der Messwerte eines oder mehrerer Messwertwandler zu schaffen, welche mit geringem Aufwand und hoher Störsicherheit eine Datenübertragung mit hoher Baudrate ermöglicht.

Diese Aufgabe wird bei einer Anordnung der eingangs genannten Gattung erfindungsgemäss gelöst durch die Merkmale des kennzeichnenden Teils des Patentanspruchs 1.

Eine vorteilhafte Ausführungsform der erfindungsgemässen Anordnung ist im Anspruch 2 angegeben.

Die erfindungsgemässe Anordnung verwendet eine serielle Übertragung der Messwertdaten synchron mit einem von der Verarbeitungseinheit vorgegebenen Takt. Die Verarbeitungseinheit kann daher die synchron übertragenen Daten unmittelbar verarbeiten, da sowohl der Beginn und das Ende des jeweils übertragenen Messwertes als auch die Anzahl und die Frequenz der übertragenen Messwert-Bits von der Verarbeitungseinheit vorgegeben werden. Aufgrund dieser unmittelbaren Verarbeitbarkeit der übertragenen Daten kann die Datenübertragung mit einer erheblich höheren Baudrate erfolgen. Es sind Baudraten von 1,5 MHz bis 2,0 MHz möglich.

Das Umschalten des Parallel-Serien-Schiebegeristers durch die Taktimpulse über die retriggerbare Zeitstufe führt dazu, dass der jeweils momentan parallel anliegende Messwert für sämtliche Messwertwandler exakt gleichzeitig gespeichert wird. Die Zahl der Bit-Stellen des Messwertes, die jeweils übertragen wird, wird durch die Impulszahl der Taktimpulsfolge durch die Verarbeitungseinheit festgelegt. Sendet die Verarbeitungseinheit nur wenige Taktimpulse pro Taktimpulsfolge aus, so wird nur eine entsprechend geringe Anzahl der höchstwertigen Bit-Stellen des Messwertes beginnend mit dem höchstwertigen Bit übertragen. Werden Messwertwandler hoher Auflösung und dementsprechend grosser Bit-Stellenzahl des Messwertes zum Messen von sich zeitlich schnell ändernden Vorgängen verwendet, so kann die Übertragung der Messwerte für eine grobe Überwachung des Vorgangs auf wenige der höchstwertigen Bit-Stellen beschränkt werden. Die Geschwindigkeit der Messwertübertragung kann dadurch wesentlich erhöht und dem sich zeitlich schnell ändern Vorgang angepasst werden, wobei auf die hohe Auflösung des Messwertwandlers bewusst verzichtet wird. Zur Feinmessung oder zur Feinpositionierung kann dann eine hohe Auflösung des Messwertwandlers bei Verlangsamung des Vorgangs ausgenützt werden, indem die Anzahl der Taktimpulse pro Taktimpulsfolge entsprechend der gesamten Bit-Stellenzahl des Messwertes erhöht wird. Diese Änderung der Anzahl der zu übertragenden Bit-Stellen zur Anpassung an die Geschwindigkeit des zu messenden Vorgangs erfolgt ausschliesslich durch die die Taktimpulsfolgen aussendende Verarbeitungseinheit, ohne dass irgendwelche Änderungen an dem Messwertwandler notwendig sind.

Ein weiterer wesentlicher Vorteil ergibt sich, wenn mehrere Messwertwandler an eine gemeinsame Verarbeitungseinheit angeschlossen sind. Die Daten sämtlicher Messwertwandler können in diesem Falle synchron mit dem Takt der Verarbeitungseinheit übertragen werden. Dadurch ist es ohne zusätzlichen Aufwand möglich, die Messwerte sämtlicher Messwertwandler exakt zeitgleich aufzunehmen und zu verarbeiten.

Der Messwertwandler verwendet den einschrittigen Gray-Code. Dadurch ist eine sichere Datenerfassung bei beliebigem Zeitpunkt der Abfrage durch die Verarbeitungseinheit gewährleistet. Ausserdem ist mit Hilfe der Taktimpulse der Verarbeitungseinheit eine einfache Umwandlung der Messwertinformation aus dem Gray-Code in den rechnerkompatiblen Dual-Code möglich.

Die erfindungsgemässe Datenübertragungsanordnung benötigt nur eine geringe Anzahl an nicht hochintegrierten elektronischen Bauteilen und nur eine geringe Anzahl an Leitungen zur Datenübertragung. Die Schnittstelle von Messwertwandler und Verarbeitungseinheit ist unabhängig von der Bitstellenzahl des Messwertes, d.h. von der Auflösung des Messwertwandlers. Aufgrund der geringen Anzahl von Datenübertragungsleitungen ist eine wenig aufwendige und störungssichere galvanische Trennung des Messwertaufnehmers von der Verarbeitungseinheit durch eine optische Kopplung möglich.

Schliesslich ermöglicht die erfindungsgemässe Datenübertragungsanordnung ohne zusätzliche Leitungen eine Überwachung des Messwertwandlers auf Störungen und eine Überwachung auf Leitungsbrüche.

Im folgenden wird die Erfindung anhand eines in der Zeichnung dargestellten Ausführungsbeispiels näher erläutert. Es zeigen:

Fig. 1 ein Blockschaltbild einer Anordnung zur seriellen Übertragung der Messwerte eines Winkelcodierers,

Fig. 2 die Impulsform der Taktimpulsfolgen,

Fig. 3 schematisch in einem Impuls-Zeit-Diagramm die Abfolge der synchronen seriellen Datenübertragung und

Fig. 4 schematisch die Anwendung der synchronen seriellen Datenübertragung auf mehrere Messwertcodierer.

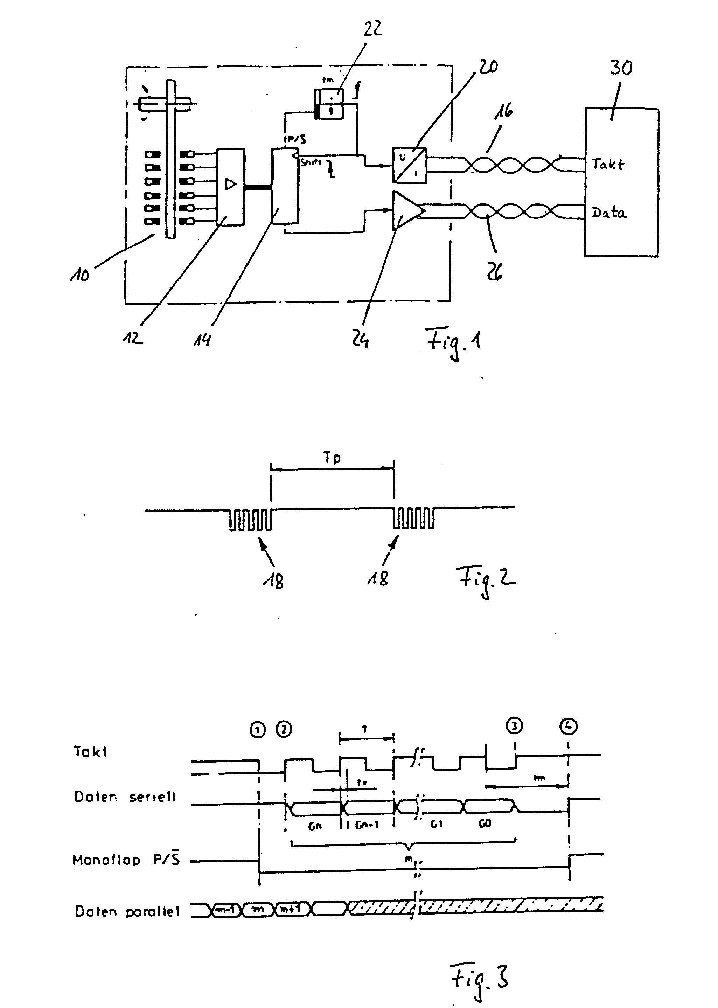

In dem in Fig. 1 dargestellten Ausführungsbeispiel ist ein Messwertwandler 10 in Form eines Absolut-Winkelcodierers vorgesehen, der die jeweilige Winkelstellung als Binär-Wort im Gray-Code angibt. Das den jeweiligen momentanen Messwert darstellende Binär-Wort liegt über einen Verstärker 12 parallel an einem Parallel-Serien-Schieberegister 14 an.

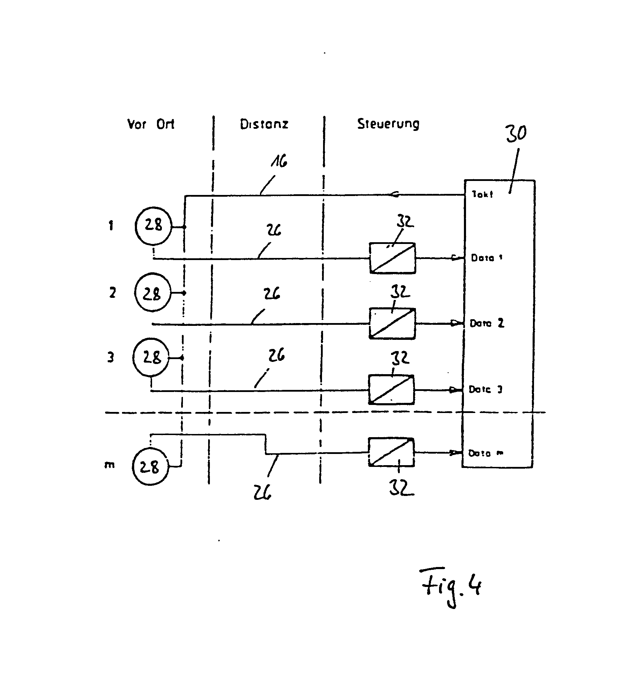

Von einer Verarbeitungseinheit 30, beispielsweise einer Steuerungseinheit, werden über eine Taktleitung 16 Taktimpulsfolgen 18, wie sie in Fig. 2 dargestellt sind, abgegeben. Über einen Strom-Spannungs-Wandler 20 gelangen die Taktimpulsfolgen 18 einerseits an den Takteingang (Shift) des Parallel-Serien-Schieberegisters 14 und andererseits an den Steuereingang einer retriggerbaren monostabilen Kippstufe (Monoflop) 22 mit einer Kipp-Periode tm. Die Kipp-Periode tm des Monoflops 22 ist grösser als die Periodendauer T der Taktimpulse der Taktimpulsfolgen 18 und kleiner als der zeitliche Abstand Tp der Taktimpulsfolgen 18. Vorzugsweise gilt

$$1,5\,T < tm < 2,5\,T.$$

Das invertierte Ausgangssignal des Monoflops 22 steuert das Parallel-Serien-Schieberegister 14 über dessen Eingang P/S vom Parallelbetrieb auf den seriellen Betrieb.

Die im Parallel-Serien-Schieberegister 14 gespeicherten Daten werden seriell ausgelesen und über einen Verstärker 24 und eine Datenleitung 26 zu der Verarbeitungseinheit übertragen.

Der Ablauf der synchronen seriellen Datenübertragung wird nachfolgend anhand der Fig. 3 näher erläutert.

Von dem Messwertwandler 10 kommen die Messwerte in Form von Gray-codierten Wörtern kontinuierlich zu dem Parallel-Serien-Schieberegister 14, wie dies in der untersten Zeile der Fig. 3 dargestellt ist. Die einzelnen Messwerte bzw. Binär-Wörter sind dabei jeweils durch einen Block m –1, m, m + 1 usw. dargestellt. Die Binärstellen der einzelnen Messwerte stehen dabei parallel an dem Parallel-Serien-Schieberegister 14 an.

Während der Zeit, in welcher keine von der Verarbeitungseinheit kommende Taktimpulsfolge 18 an dem Parallel-Serien-Schieberegister 14 ankommt, ist das Parallel-Serien-Schieberegister auf parallel geschaltet, und die Messwerte liegen in Form der Binär-Wörter m –1, m, m + 1 usw. transparent parallel am dem Schieberegister 14 an.

Trifft eine Taktimpulsfolge 18 ein, wie sie in Fig. 3 in der obersten Zeile dargestellt ist, die vorzugsweise aus Rechteckimpulsen besteht, so wird zu Beginn des ersten Taktimpulses, z.B. beim Übrgang von 20 mA auf 0 mA zum Zeitpunkt 1 das retriggerbare Monoflop 22 angesteuert. Das in Fig. 3 in der dritten Zeile dargestellte invertierte Ausgangssignal des Monoflops 22 steuert das Parallel-Serien-Schieberegister auf seriell. Das bei diesem Umschalten zum Zeitpunkt 1 parallel am Parallel-Serien-Schieberegister anliegende Messwert-Binär-Wort m wird gespeichert.

Am Ende des ersten Taktimpulses, wenn zum Zeitpunkt 2 das Taktsignal wieder von low (z.B. 0 mA) auf high (z.B. 10 mA) wechselt, wird das höchststellige Bit Gn des Gray-codierten Binär-Wortes m an den seriellen Datenausgang des Parallel-Serien-Schieberegisters 14 gelegt und über die Datenleitung 26 zu der Verarbeitungseinheit übertragen. Mit jeder weiteren ansteigenden Flanke der Taktimpulsfolge werden nacheinander die jeweils nächst niederwertigen Bits Gn −1, ... G1, G0 an den Datenausgang des Parallel-Serien-Schieberegisters 14 geschoben und über die Datenleitung 26 übertragen.

Ist das niederwertigste Bit G0 übertragen, schaltet zum Zeitpunkt 3 das in Fig. 3 in der zweiten Zeile dargestellte Signal am Datenausgang des Schieberegisters 14 bzw. auf der Datenleitung 26 auf low (0 Volt), bis die Kipp-Periode tm des Monoflops 22 abgelaufen ist, die bei jeder fallenden Flanke der Taktimpulsfolge 18 erneut getriggert wird. Das Signal der Datenleitung 26 zeigt somit der Verarbeitungseinheit an, dass die Schaltung noch nicht für eine weitere Übertragung bereit ist.

Nach Ablauf der letzten Kipp-Periode tm geht das Monoflop 22 wieder in seinen stabilen Zustand, das Parallel-Serien-Schieberegister 14 wird durch den Ausgang des Monoflops 22 wieder auf parallel geschaltet und das Signal auf der Datenleitung 26 geht zum Zeitpunkt 4 wieder auf high. Die Anordnung ist somit für die nächste Datenübertragung bereit.

Soll ein Messwertwandler mit Selbstüberwachung eingesetzt werden, so kann auf eine gesonderte Meldeleitung verzichtet werden. Eine Störung des Messwertwandlers wird dann ebenfalls durch die Spannung 0 Volt auf der Datenleitung 26 angezeigt. Eine weiteren Datenübertragung ist dadurch blockiert.

Aus diesem vorstehend beschriebenen Ablauf der Datenübertragung ergibt sich die Anzahl der Taktimpulse, die pro Taktimpulsfolge 18 für die Übertragung erforderlich ist. Ist n der Exponent des höchstwertigen Bit des binär codierten Messwertes (z.B. n = 10 bei $2^{10}$), dann ist die Anzahl L der zu übertragenden Bits des Messwertes L = n + 1 und die Anzahl K der steigenden Flanken der Taktimpulsfolge 18 und damit die Zahl der Impulse pro Taktimpulsfolge 18 K = L + 1 = n + 2. Die Anzahl der zur Übertragung erforderlichen Impulse pro Taktimpulsfolge 18 ist somit von der Binär-Stellenzahl des Messwertes und damit von der Auflösung des Messwertwandlers 10 abhängig.

In Fig. 4 ist dargestellt, wie die synchrone serielle Datenübertragung vorteilhaft eingesetzt werden kann, wenn mehrere Messwertwandler an eine gemeinsame Verarbeitungseinheit, beispielsweise an eine gemeinsame Steuerung, angeschlossen sind.

Die Messwertwandler mit der gesamten in Fig. 1 dargestellten strichpunktiert umrahmten Schaltungsanordnung sind in Fig. 4 jeweils durch Kreise 28 gekennzeichnet. Die durch die Kreise 28 gekennzeichnete Anordnung der Fig. 1 ist jeweils am Einsatzort des Messwertwandlers montiert. Über eine gemeinsame verdrillte und abgeschirmte Taktleitung 16 und jeweils eine jedem Messwertwandler zugeordnete verdrillte und abgeschirmte Datenleitung 26 sind die Schaltungsanordnungen 28 mit der entfernt angeordneten Verarbeitungseinheit beispielsweise einer Steuereinheit 30 verbunden.

Über die Taktimpulsfolgen 18 einer einzigen gemeinsamen Taktleitung 16 können die Messwerte sämtlicher Messwertwandler gleichzeitig parallel ausgelesen werden. Durch den gemeinsamen von der Verarbeitungseinheit erzeugten Takt ist eine synchrone Datenübertragung sämtlicher Messwertwandler gewährleistet. Die synchrone Datenübertragung von allen Messwertwandlern vereinfacht nicht nur die Datenverarbeitung in der Steuereinheit sondern gewährleistet auch eine exakt zeitgleiche Messwertzuordnung sämtlicher Messwertwandler, z.B. die zeitgleiche Winkelzuordnung verschiedener Achsen, ohne eine zusätzliche Speicherleitung.

Die im Gray-Code übertragenen Messwertdaten können über Wandler 32 in den Dual-Code umgewandelt werden, der sich für die Verarbeitung in der Steuereinheit eignet.

**Patentansprüche**

1. Anordnungn zur seriellen Übertragung der Messwerte wenigstens eines Messwertwandlers (10), insbesondere eines Winkelcodierers oder Wegmesscodierers, mit jeweils einem dem Messwertwandler (10) zugeordneten Parallel-Serien-Schieberegister (14), an welchem der binär-codierte Messwert des Messwertwandlers (10) parallel anliegt, mit einem Taktimpulsgenerator, der Taktimpulsfolgen (18) dem Takteingang der Parallel-Serien-Schieberegister (14) zuführt, mit einer den Serien-Ausgang der Parallel-Serien-Schieberegister (14) mit einer Verarbeitungseinheit (30) verbindenden Datenleitung (26) und mit jeweils einer dem Parallel-Serien-Schieberegister (14) zugeordneten retriggerbaren Zeitstufe, deren Zeitkonstante länger als die Taktperiode der Taktimpulsfolgen (18), aber kürzer als der zeitliche Abstand der Taktimpulsfolgen (18) ist, dadurch gekennzeichnet, dass die Messwerte jeweils im Gray-Code an dem Parallel-Serien-Schieberegister (14) anliegen, dass der Taktimpulsgenerator in der Verarbeitungseinheit (30) vorgesehen ist, dass jedes Parallel-Serien-Schieberegister (14) über eine gesonderte Datenleitung (26) mit der Verarbeitungseinheit (30) verbunden ist und dass die Taktimpulsfolgen (18) jeweils über die retriggerbare Zeitstufe dem Parallel-Serien-Umschalteingang (P/S) des Parallel-Serien-Schieberegisters (14) zugeführt werden, wobei der jeweils erste Impuls der Taktimpulsfolgen (18) die Speicherung des im Gray-Code parallel anstehenden Messwertes auslöst.

2. Anordnung nach Anspruch 1, dadurch gekennzeichnet, dass die retriggerbaren Zeitstufen monostabile Kippstufen (22) sind.

**Claims**

1. A system for transmitting in serial fashion measuring data of at least one transducer (10), and more particularly of an angle encoder or a position sensing encoder, comprising parallel-serial shifting registers (14) associated to each transducer (10), and to which is applied in parallel the binary-coded value measured by said transducer (10), a timing-pulse generator transmitting timing-pulse sequences (18) to the clock input of said parallel-serial shifting registers (14), a data line (26) connecting the serial output of said parallel-serial shifting registers (14) to a processing unit (30), and a retriggerable time stage associated to each parallel-serial shifting register (14), the time constant of which is longer than the clock period of said timing-pulse sequences (18), but shorter than the time interval between said timing-pulse sequences (18), characterized in that the measured values are applied to said parallel-serial shifting register (14) in accordance with the Gray code, that said timing-pulse generator is provided in the processing unit (30), that each parallel-serial shifting register (14) is connected to said processing unit (30) through a separate data line (26), and that said timing-pulse sequences (18) are transmitted to the parallel-serial switching input (P/S) of said parallel-serial shifting register (14) through the retriggerable time stage, the first pulse of each timing-pulse sequence (18) causing the measured value applied in parallel in accordance with the Gray code to be stored.

2. The system as claimed in claim 1, characterized in that the retriggerable time stages are monostable trigger circuits (22).

**Revendications**

1. Dispositif pour la transmission sérielle des valeurs mesurées d'au moins un transducteur (10), notamment d'un capteur rotatif ou d'un capteur de déplacement, comportant un registre de décalage parallèle-série (14) affecté à chaque transducteur (10) et auquel est appliquée la valeur de mesure codée en binaire du transducteur (10) en parallèle, un générateur d'impulsions de rythme qui transmet des séquences d'impulsions de rythme (18) à l'entrée de rythme des registres de décalage parallèle-série, une ligne de transmission de données (26) reliant la sortie série du registre de décalage parallèle-série (14) à l'unité de traitement (30), et un étage de temps redéclenchable affecté à chaque registre de décalage parallèle-série (14), dont la constante de temps est plus longue que la période de rythme des séquences d'impulsions de rythme (18), mais plus courte que l'intervalle entre les séquences d'impulsions de rythme (18), caractérisé en ce que les valeurs de mesure sont appliquées au registre de décalage parallèle-série (14) suivant le code Gray, que le générateur d'impulsions de rythme est prévu dans l'unité de traitement (30), que chaque registre de décalage parallèle-série (14) est relié à l'unité de traitement (30) par une ligne de transmission de données (26) séparée, et que les sequences d'impulsions de rythme (18) sont transmises à l'entrée de commutation parallèle-série (P/S) du registre de décalage parallèle-série (14) par l'étage de temps redéclenchable, la première impulsion de chaque sequence d'impulsions de rythme (18) provoquant la mise en mémoire de la valeur mesurée appliquée en parallèle suivant le code Gray.

2. Dispositif conforme à la revendication 1, caractérisé en ce que les étages de temps redéclenchables sont des étages de multivibrateur monostable (22).

Fig. 1

Fig. 2

Fig. 3

Fig. 4